# EUROPEAN PATENT SPECIFICATION

(11) **EP 3 627 627 B1**
(45) Date of publication and mention of the grant of the patent: **11.11.2020**
(21) Application number: 17909773.8
(22) Date of filing: 15.05.2017
(51) Int. Cl.: H01R 12/71, H01R 13/502, H01R 13/629, H04B 1/3818, A45C 11/18, G06K 13/08, H04M 1/02

(54) **CARD BRACKET AND ELECTRONIC DEVICE**
KARTENKLAMMER UND ELEKTRONISCHE VORRICHTUNG
SUPPORT DE CARTE ET DISPOSITIF ÉLECTRONIQUE

(43) Date of publication of application: 25.03.2020
(73) Proprietor: GUANGDONG OPPO MOBILE TELECOMMUNICATIONS CORP., LTD., Wusha, Chang'an Dongguan, Guangdong 523860 (CN)
(72) Inventor: ZENG, Yuanqing, Dongguan Guangdong 523860 (CN)
(74) Representative: Mewburn Ellis LLP
(86) International application number: PCT/CN2017/084344
(87) International publication number: WO 2018/209496

(56) References cited:
- CN-A- 104 065 771
- CN-A- 104 300 305
- CN-A- 107 171 089
- CN-U- 204 793 416
- CN-U- 206 743 228
- US-A1- 2014 177 160
- US-A1- 2014 247 568
- US-A1- 2015 022 981

## Description

### TECHNICAL FIELD

The present disclosure relates to the technology field of electronic devices, and more particularly to a card bracket and a terminal.

### BACKGROUND

Generally, electrical connection between an electronic device and a data card can be realized by placing the data card on a card bracket, and then pushing the card bracket into the electronic device. When users need to take out the card bracket, a card needle is usually used to pass through a through hole on the card bracket to push the card bracket out. However, in the absence of the card needle, it is difficult to take out the card bracket.
US 2014/0247568 A1 discloses an electronic device including a case, a switch, a connecting tray and a moving member.
US 2015/0022981 A1 discloses an electronic card connection device comprising a connector, an electronic card tray and a switch; and a connector comprising a terminal housing and a shell, wherein the shell and the terminal housing define a mating space for receiving the electronic card.
US 2014/0177160 A1 discloses a chip card holder including a housing, a receiving frame, an elastic member, a tray, and a protective cover.

### SUMMARY

Implementations of the present disclosure provide a card bracket and a terminal.

The card bracket according to the implementations of the present disclosure is applied to a terminal. The card tray is capable of accommodating a data card and is insertable into a housing of the terminal. The card bracket includes a card tray configured to accommodate the data card; and a card cover coupled to the card tray and rotatable relative to the card tray, the card cover including a first end and a second end opposite to each other, the card cover further including a first protrusion extending toward the card tray. When the card bracket is in a state of being inserted into the housing and a push force is applied to the first end, the card cover is rotatable about the first protrusion, to cause the first end to further extend into the housing while the second end to extend out of the housing. The card tray is provided with a connecting plate at an end adjacent to the card cover. The card bracket further includes a first connecting rod. The first connecting rod includes a first sliding end slidably coupled to the connecting plate; and a first rotating end rotatably coupled to the first protrusion, where the first connecting rod is driven to slide relative to the connecting plate, and/or the first connecting rod is driven to rotate relative to the first protrusion, by pushing the card cover toward or away from the card tray.

In some implementations, the connecting plate is provided with a first sliding slot, and the first protrusion is formed with a first shaft hole. The card bracket further includes a first sliding shaft passing through the first sliding slot and fixedly connected to the first sliding end, where the first sliding end is able to drive the first sliding shaft to slide in the first sliding slot, where the first sliding shaft is integrally formed or separately formed with the first sliding end; and a first rotating shaft passing through the first rotating end and the first shaft hole, where the first rotating end is rotatable about the first rotating shaft.

In some implementations, the first connecting rod includes a first upper plate and a first lower plate that are spaced apart, where the first upper plate and the first lower plate corporate to define a first receiving space therebetween, where the connecting plate extends out of or partially extends into the first receiving space when the card cover is pulled away from or pushed toward the card tray.

In some implementations, the card cover further includes a second protrusion extending toward the card tray. The card bracket further includes a second connecting rod. The second connecting rod includes a second sliding end slidably coupled to the connecting plate; and a second rotating end rotatably coupled to the second protrusion. The second connecting rod is driven to slide relative to the connecting plate, and/or the second connecting rod is driven to rotate relative to the second protrusion, by pushing the card cover toward or away from the card tray.

In some implementations, the connecting plate is provided with a second sliding slot, and the second protrusion is formed with a second shaft hole. The card bracket further includes a second sliding shaft passing through the second sliding slot and fixedly connected to the second sliding end, where the second sliding end is able to drive the second sliding shaft to slide in the second sliding slot, where the second sliding shaft is integrally formed or separately formed with the second sliding end; and a second rotating shaft passing through the second rotating end and the second shaft hole, where the second rotating end is rotatable about the second rotating shaft.

In some implementations, the second connecting rod includes a second upper plate and a second lower plate that are spaced apart, where the second upper plate and the second lower plate are corporate to define a second receiving space therebetween. The connecting plate extends out of or partially extends into the second receiving space when the card cover is pulled away from or pushed toward the card tray.

In some implementations, the card cover is provided with a receiving groove on one side close to the card tray. When the card cover is pushed toward the card tray, the first connecting rod rotates relative to the first protrusion and is finally received in the receiving groove, and the second connecting rod rotates relative to the second protrusion and is finally received in the receiving groove.

In some implementations, the card cover is provided with a first side surface at the first end and a second side surface at the second end where the first side surface gradually approaches a middle position of the card cover in a direction from the card tray to the card cover, and the second side surface is gradually away from the middle position of the card cover in the direction from the card tray to the card cover.

In some implementations, the card bracket further includes a connecting element extending from the second end toward the card tray, where when the card bracket is in a state of being inserted into the housing, the connecting element extends into the housing for connecting the card cover to the housing.

In some implementations, the card bracket further includes a jointing element arranged in the housing, where when the card bracket is in the state of being inserted into the housing, the connecting element is detachably connected to the jointing element, to connect the card cover with the housing.

In some implementations, the card bracket further includes a sealing element arranged on a sidewall of the card cover. When the card cover extends into the housing, the sealing element is located between the card cover and the housing and seals a gap between the card cover and the housing.

The terminal according to the implementation of the disclosure includes a housing provided with a card insertion groove; and the card bracket of any one of the above implementations, where the card bracket is insertable into the housing by extending into the card insertion groove.

In some implementations, the card bracket further includes a jointing element, and the housing further includes a fixing element on which the jointing element is fixedly arranged, where when the card bracket is in a state of being inserted into the housing, the jointing element is detachably connected to the card cover.

In some implementations, the terminal further includes a card base arranged in the housing, and the card base is provided with a guiding slot, where the card tray extends into the guiding slot when the card bracket is inserted into the housing.

In some implementations, the card bracket includes a bottom wall, a top wall and a sidewall, where the bottom wall is opposite to the top wall, the sidewall connects the bottom wall to the top wall, and the bottom wall, the top wall and the sidewall corporate to form the guiding slot.

In some implementations, the card bracket further includes a sealing element arranged on a sidewall of the card cover, where when the card cover extends into the card insertion groove, the sealing element is located between the card cover and an inner wall of the card insertion groove and seals a gap between the card cover and the inner wall.

In the above-mentioned card tray and terminal, when it is necessary to remove the card bracket from the housing, only the first end needs to be pushed, so that the card cover may be rotated to make the second end extend out of the housing, and the entire card bracket may be taken out by further pulling the second end, thereby making it possible to remove the card bracket from the housing in the absence of a card needle, which greatly facilitates the user.

The additional aspects and advantages of the implementations of the present disclosure will be given in the following description, and will become apparent from the following description, or will be understood through implementing the implementations of the present disclosure.

### BRIEF DESCRIPTION OF THE DRAWINGS

The above and/or additional aspects and advantages of the present disclosure will become apparent and readily understood from the description of the implementations in conjunction with the following drawings.
FIG 1 is a three-dimensional schematic diagram of a terminal according to an implementation of the present disclosure.
FIG 2 is an enlarged schematic diagram of a portion II of the terminal of FIG 1.
FIG 3 is an enlarged partial cross-sectional view showing a position of the terminal corresponding to the portion II of FIG 1 according to the implementation of the present disclosure.
FIG 4 is an enlarged partial cross-sectional view showing a position of the terminal corresponding to the portion II of FIG 1 according to the implementation of the present disclosure.
FIG 5 is an enlarged partial cross-sectional view showing a position of the terminal corresponding to the portion II of FIG 1 according to the implementation of the present disclosure.
FIG 6 is an enlarged partial cross-sectional view showing a position of the terminal corresponding to the portion II of FIG 1 according to the implementation of the present disclosure.
FIG 7 is a three-dimensional schematic diagram of a card bracket according to an implementation of the present disclosure.
FIG 8 is a three-dimensional schematic diagram of a card bracket according to an implementation of the present disclosure.
FIG 9 is a three-dimensional explosion schematic diagram of a card bracket according to an implementation of the present disclosure.

### DESCRIPTION OF SYMBOLS OF MAIN COMPONENTS

Terminal 100, card bracket 10, card tray 11, card tray body 112, card slot 1122, connecting plate 114, first sliding slot 1141, first side end 1142, first middle end 1143, second sliding slot 1144, second side ends 1145, second middle end 1146, card cover 12, first end 121, first side surface 1212, second end 122, second side surface 1222, first protrusion 123, first shaft hole 1232, second protrusion 124, second shaft hole 1242, receiving groove 125, sealing element 13, connecting element 14, guiding inclined surface 142, jointing element 15, first connecting rod 16, first sliding end 161, first rotating end 162, first upper plate 163, first lower plate 164, first receiving space 165, first sliding shaft 17, first rotating shaft 18, second connecting rod 19, second sliding end 191, second rotating end 192, second upper plate 193, second lower plate 194, second receiving space 195, second sliding shaft 1a, second rotating shaft 1b, housing 20, card insertion groove 22, inner wall 222, first inner wall 2222, second inner wall 2224, fixing element 24, card base 30, guiding slot 32, bottom wall 34, top wall 36, sub-top wall 362, sidewall 38, avoidance space 39, and data card 200.

### DETAILED DESCRIPTION

Implementations of the present disclosure will be further described below in conjunction with the accompanying drawings. The same or similar reference numerals in the drawings denote the same or similar elements or elements having the same or similar functions.

In addition, the implementations of the present disclosure described below in conjunction with the accompanying drawings are merely illustrative of the implementations of the present disclosure, rather than being construed as limiting.

In the present disclosure, unless otherwise explicitly stated and defined, a first feature "on" or "under" a second feature may include that the first and second features are in direct contact, or the first and second features are in indirect contact through an intermediate medium. Moreover, the first feature "above", "over" and "on top of' the second feature may include that the first feature is directly above or indirectly above the second feature, or merely indicates that the level of the first feature is higher than that of the second feature. The first feature "below", "under" and "at the bottom of' the second feature may include that the first feature is directly below or indirectly below the second feature, or merely indicates that the level of the first feature is lower than the second feature.

The implementation of the present disclosure provides a card bracket which is applied to a terminal. The card bracket is capable of accommodating a data card and is insertable into a housing of the terminal. The card bracket includes a card tray and a card cover. The card tray is configured to accommodate the data card. The card cover is coupled to the card tray and is rotatable relative to the card tray. The card cover includes a first end and a second end opposite to each other. The card cover further includes a first protrusion extending toward the card tray. When the card bracket is in a state of being inserted into the housing and a push force is applied to the first end, the card cover is rotatable about the first protrusion, to cause the first end to further extend into the housing while the second end to extend out of the housing.

The implementation of the present disclosure further provides a terminal which includes a housing and the above card bracket. The housing is provided with a card insertion groove. The card bracket is insertable into the housing by extending into the card insertion groove.

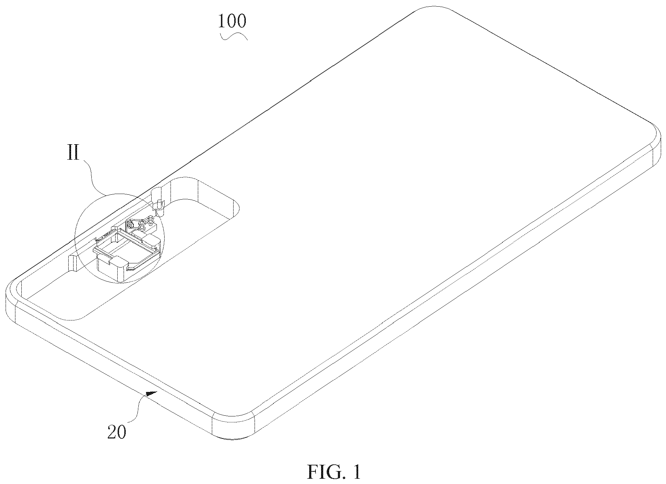

Referring to FIGS. 1 to 3, a terminal 100 according to an implementation of the present disclosure includes a housing 20 and a card bracket 10. The housing 20 is provided with a card insertion groove 22. The card bracket 10 is insertable into the housing 20 by extending into the card insertion groove 22.

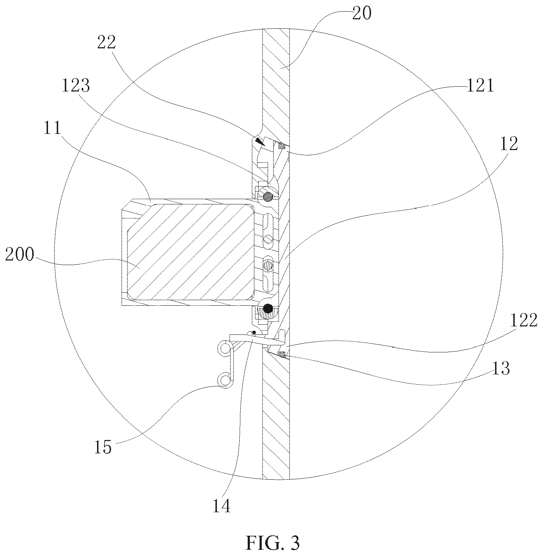

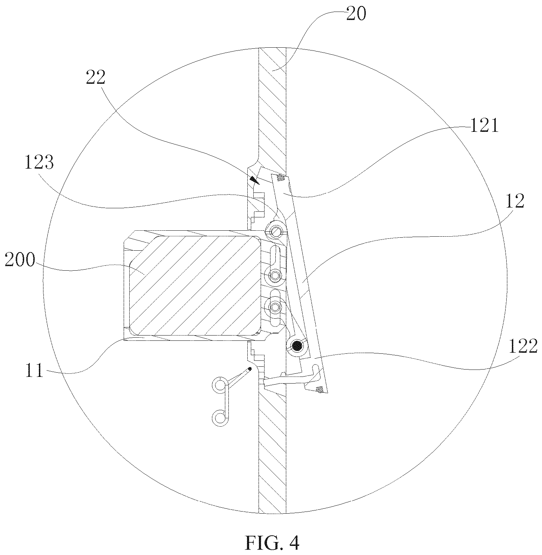

Referring to FIGS. 3 to 6, the card bracket 10 of the implementation of the present disclosure may be applied to the terminal 100 of the implementation of the present disclosure. The card bracket 10 is capable of accommodating the data card 200 and be insertable into the housing 20 of the terminal 100. The card bracket 10 includes a card tray 11 and a card cover 12. The card tray 11 is configured to accommodate the data card 200. The card cover 12 is coupled to the card tray 11, and is rotatable relative to the card tray 11. The card cover 12 includes a first end 121 and a second end 122 opposite to each other. The card cover 12 further includes a first protrusion 123 extending toward the card tray 11. When the card bracket 10 is in a state of being inserted into the housing 20 (as illustrated in FIG 3) and a push force is applied to the first end 121, the card cover 12 is rotatable about the first protrusion 123, so that the first end 121 further extends into the housing 20 while the second end 122 extends out of the housing 20 (as illustrated in FIG 4).

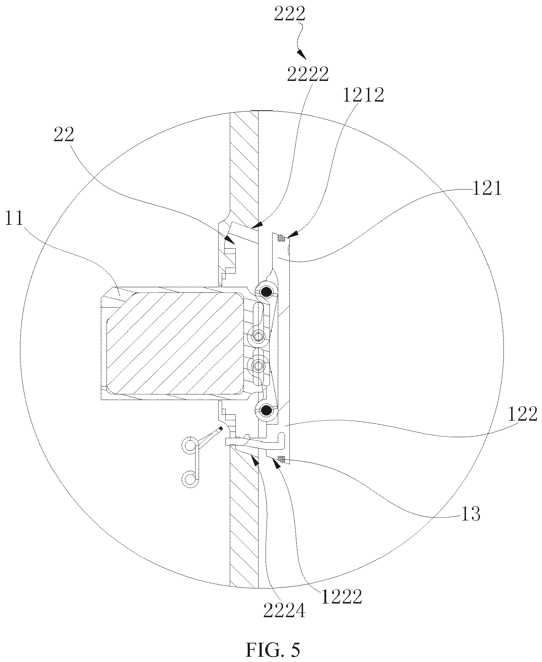

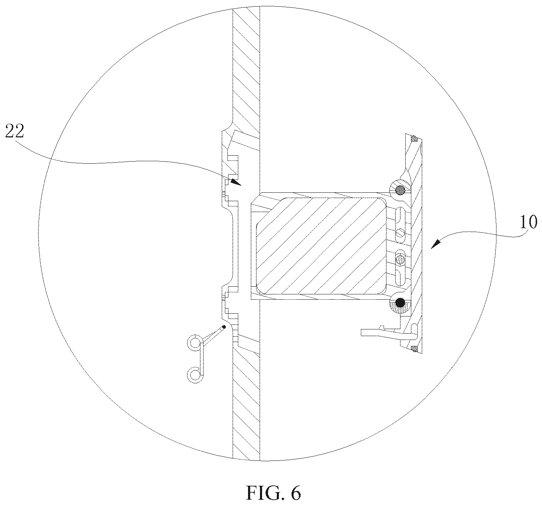

In this way, when it is necessary to remove the card bracket 10 from the housing 20, only the first end 121 needs to be pushed, so that the card cover 12 may be rotated to make the second end 122 extend out of the housing 20, and the entire card bracket 10 may be taken out by further pulling the second end 122 (as illustrated in FIGS. 5 and 6), thereby making it possible to remove the card bracket 10 from the housing 20 in the absence of a card needle, which greatly facilitates the user.

Further, when it is necessary to insert the card bracket 10 into the card insertion groove 22, the card bracket 10 is first aligned with the card insertion groove 22 (as illustrated in FIG 6). Then, the card bracket 10 is gradually inserted into the card insertion groove 22. Specifically, the card tray 11 may be first inserted into the card insertion groove 22 (as illustrated in FIG 5). Then, the first end 121 is pushed to make the card cover 12 rotate around the first protrusion 123. At this time, the first end 121 first extends into the card insertion groove 22 while the second end 122 is still outside the card insertion groove 22 (as illustrated in FIG 4). Finally, the second end 122 is pushed while the first end 121 is pressed, to push the entire card cover 12 completely into the card insertion groove 22 (as illustrated in FIG 3).

Specifically, the first protrusion 123 is located near the first end 121, which makes the distance between the first end 121 and the first protrusion 123 is less than the distance between the second end 122 and the first protrusion 123. According to the principle of leverage, when the first end 121 is pushed to rotate the card cover 12 around the first protrusion 123, a rotation travel of the second end 122 is greater than that of the first end 121. Thus, a longer portion of the second end 122 extends out of the card insertion groove 22, which is convenient for the user to grasp the second end 122 and take out the entire card bracket 10.

The terminal 100 may be various devices capable of acquiring data from the data card 200 and processing the data, or capable of importing data into the data card 200. For example, the terminal 100 may be a mobile phone, a tablet computer, a computing device, or an information display device, etc. The housing 20 may be a frame and an outer shell of the terminal 100 for carrying and protecting internal components of the terminal 100.

The data card 200 may be a data card such as a SIM card, a TF card, or an SD card. The card tray 11 is able to accommodate either one data card 200 or a plurality of data cards 200, such as two. The plurality of data cards 200 may be stacked or placed side by side.

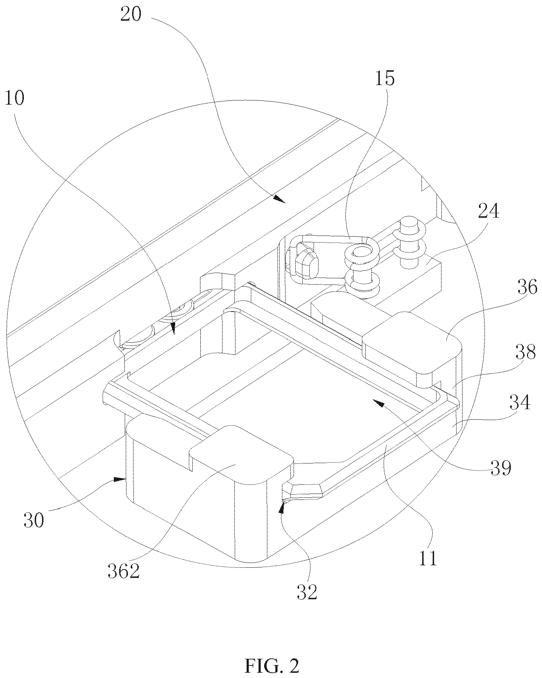

Referring to FIG 2 again, in some implementations, the terminal 100 further includes a card base 30, which is arranged in the housing 20. The card base 30 is provided with a guiding slot 32. When the card bracket 10 is inserted into the housing 20, the card tray 11 extends into the guiding slot 32.

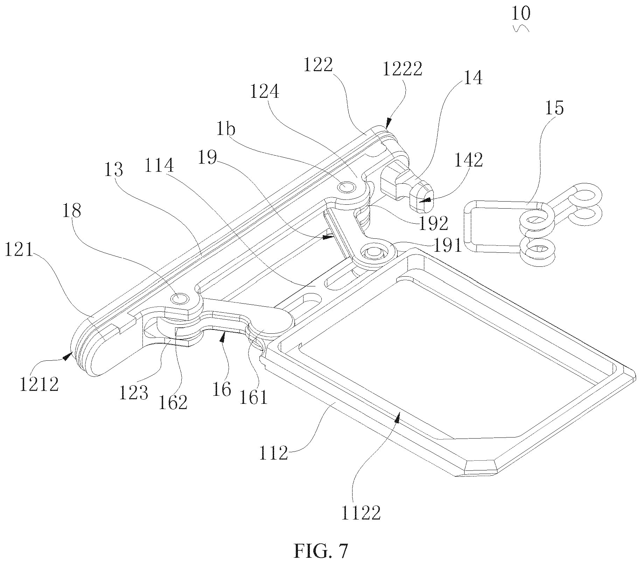

Specifically, referring to FIG 7, the card tray 11 includes a card tray body 112. The card tray body 112 is provided with a card slot 1122, and the data card 200 is placed in the card slot 1122. The peripheral walls of the card slot 1122 limits the movement of the data card 200 in an insertion plane of the card slot 1122. When the card bracket 10 is inserted into the housing 20, the card tray body 112 extends into the guiding slot 32 and abuts against the inner walls of the guiding slot 32. Under the guidance of the guiding slot 32, the card bracket 10 is easily inserted into the housing 20 and the insertion direction of the card bracket 10 is easy to control. The extending direction of the guiding slot 32 is the same as the depth direction of the card insertion groove 22, so as to make it easy for the car tray 11 to enter the guiding slot 32 after passing through the card insertion groove 22.

Specifically, referring to FIG. 2 again, in some implementations, the card base 30 includes a bottom wall 34, a top wall 36, and a sidewall 38. The bottom wall 34 is opposite to the top wall 36. The sidewall 38 connects the bottom wall 34 to the top wall 36. The bottom wall 34, the top wall 36 and the sidewall 38 cooperate to form a guiding slot 32. More specifically, the top wall 36 may include two sub-top walls 362 opposite to each other and spaced apart, the sidewall 38 may include two sub-sidewalls opposite to each other, and each sub-top wall 362 is connected to the bottom wall 34 through a corresponding sub-sidewall. An avoidance space 39 is defined between the two sub-top walls 362, so that contact terminals (not illustrated) of the terminal 100 are able to be electrically connected to the data card 200 through the avoidance space 39.

Referring to FIG 5 again, in some implementations, the card bracket 10 further includes a sealing element 13 arranged on a sidewall of the card cover 12. When the card cover 12 extends into the housing 20, the sealing element 13 is located between the card cover 12 and the housing 20, and seals a gap between the card cover 12 and the housing 20.

Specifically, when the card cover 12 is inserted into the card insertion groove 22, the sealing element 13 is located between the card cover 12 and an inner wall 222 of the card insertion groove 22, and seals the gap between the card cover 12 and the inner wall 222. Thus, the sealing element 13 can be used to prevent moisture or dust from entering the terminal 100 from the gap between the card cover 12 and the inner wall 222. In addition, friction force can be generated between the sealing element 13 and the card cover 12, as well as the sealing element 13 and the inner wall 222. The friction force prevents the card bracket 10 from sliding out of the card insertion groove 22 and falling off when the card bracket 10 is subjected to vibration. In the implementation of the present disclosure, the sealing element 13 has a ring shape and is sleeved on the sidewall of the card cover 12 to surrounds the periphery of the card cover 12. The sealing element 13 can be made of materials such as silica gel, rubber, etc.

In some implementations, the card cover 12 is provided with a first side surface 1212 at the first end 121 and a second side surface 1222 at the second end 122.

Correspondingly, the inner wall 222 of the card insertion groove 22 includes a first inner wall 2222 and a second inner wall 2224. When the card bracket 10 is inserted into the card insertion groove 22, the first inner wall 2222 is engaged with the first side surface 1212, and the inner wall 2224 is engaged with the second side surface 1222. In the implementation, the first side surface 1212 and the second side surface 1222 are slopes and parallel to each other, which makes the first end 121 be able to further extend into the card insertion groove 22 while the second end 122 be able to extend out of the card insertion groove 22, when the first end 121 is pushed to rotate the card cover 12 around the first protrusion 123. That is, when the card bracket 10 is fully inserted into the card insertion groove 22, if the first end 121 is pushed toward the card tray 11 to rotate the card cover 12 around the first protrusion 123, the first end 121 further extends into the card insertion groove 22 while the second end 122 extends out of the card insertion groove 22. Correspondingly, the first inner wall 2222 and the second inner wall 2224 are slopes and parallel to each other.

Thus, when the first end 121 is pushed to rotate the card cover 12 around the first protrusion 123, the first end 121 and the second end 122 will not interfere with the inner wall 222 of the card insertion groove 22, and the card cover 12 can be inserted into the card insertion groove 22.

Referring FIGS. 2 and 3, in some implementations, the card bracket 10 further includes a connecting element 14 extending from the second end 122 toward the card tray 11. When the card bracket 10 is in the state of being inserted into the housing 20, the connecting element 14 extends into the housing 20 for connecting the card cover 12 to the housing 20. Further, in some implementations, the card bracket 10 further includes a jointing element 15 arranged in the housing 20. When the card bracket 10 is in the state of being inserted into the housing 20, the connecting element 14 and the jointing element 15 can be detachably connected to each other, to connect the card cover 12 with the housing 20.

Specifically, the specific structures of the connecting element 14 and the jointing element 15 can be variously selected. Referring to FIG 7, in the implementation of the present disclosure, the connecting element 14 is a hook, the jointing element 15 is a buckle. An end portion of the connecting element 14 is formed with a guiding inclined surface 142. When the connecting element 14 gradually extends into the housing 20 and contacts with the jointing element 15, the jointing element 15 abuts against the guiding inclined surface 142. When the connecting element 14 is further pushed inward, the connecting element 14 is engaged with the jointing element 15. When it is necessary to remove the card bracket 10, the connecting element 14 is disengaged from the jointing element 15 under a pulling action of the second end 122.

Further, in some implementations, referring to FIG 2, the housing 20 further includes a fixing element 24 on which the jointing element 15 is fixedly arranged. In the implementation of the present disclosure, the jointing element 15 is wound around the fixing element 24, so that one end of the jointing element 15 that is engaged with the connecting element 14 has a higher freedom to realize a detachable fitting between the connecting element 14 and the jointing element 15.

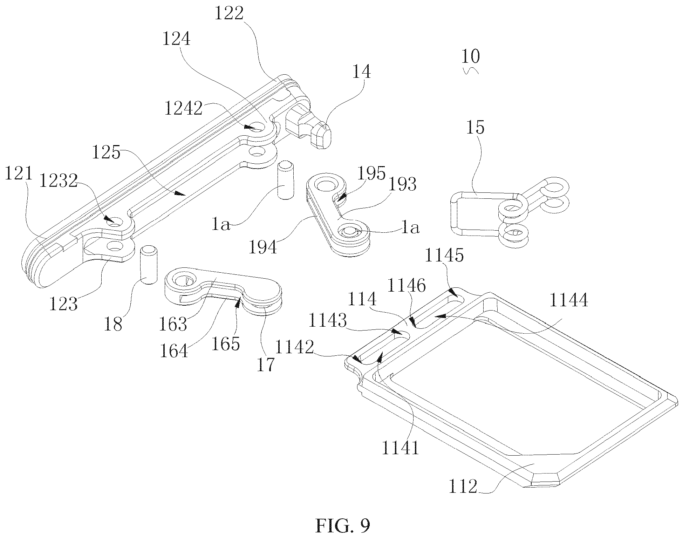

Referring to FIGS. 7 to 9, in some implementations, the card tray 11 is provided with a connecting plate 114 at an end adjacent to the card cover 12. The card bracket 10 further includes a first connecting rod 16 that includes a first sliding end 161 and a first rotating end 162. The first sliding end 161 is slidably coupled to the connecting plate 114, and the first rotating end 162 is rotatably coupled to the first protrusion 123. Pushing the card cover 12 toward or away from the card tray 11 can drive the first connecting rod 16 to slide relative to the connecting plate 114 and/or drive the first connecting rod 16 to rotate relative to the first protrusion 123.

Thus, the card tray 11 is movably connected to the card cover 12, and the relative positions between the card tray 11 and the card cover 12 can be adjusted by adjusting the position of the first sliding end 161 or adjusting the angle of the first rotating end 162 relative to the card cover 12. Specifically, when it is necessary to remove the card bracket 10 from the housing 20, the first connecting rod 16 can be driven to move by pulling the second end 122 that extends out of the card insertion groove 22, so that the distance between the card cover 12 and the card tray 11 is larger, which makes it convenient for the user to grasp the card cover 12, or simultaneously grasp the card cover 12 and the first connecting rod 16, in order to further pull out the card tray 11.

It can be understood that, the motion state of the first connecting rod 16 includes a motion state in which the first sliding end 161 slides relative to the connecting plate 114 and the first rotating end 162 is stationary relative to the first protrusion 123; a motion state in which the first rotating end 162 rotates relative to the first protrusion 123 and the first sliding end 161 is stationary relative to the connecting plate 114; and a motion state in which the first rotating end 162 rotates relative to the first protrusion 123 and the first sliding end 161 slides relative to the connecting plate 114. Thus, the relative positional relationship between the card cover 12 and the card tray 11 is more diverse, so that the user can perform various operations on the card bracket 10.

Specifically, in some implementations, the connecting plate 114 is provided with a first sliding slot 1141, and the first protrusion 123 is formed with a first shaft hole 1232. The card bracket 10 further includes a first sliding shaft 17 and a first rotating shaft 18. The first sliding shaft 17 passes through the first sliding slot 1141 and is fixedly connected to the first sliding end 161. The first sliding end 161 can drive the first sliding shaft 17 to slide in the first sliding slot 1141. The first sliding shaft 17 and the first sliding end 161 are integrally formed or separately formed. The first rotating shaft 18 passes through the first rotating end 162 and the first shaft hole 1232. The first rotating end 162 is rotatable about the first rotating shaft 18.

Thus, the connection structures of the card tray 11, the card cover 12 and the first connecting rod 16 are simple and easy to disassemble and assemble. The extending direction of the first sliding slot 1141 may be perpendicular to the direction in which the card bracket 10 is inserted into the housing 20. The first sliding slot 1141 includes a first side end 1142 and a first middle end 1143. The first side end 1142 is closer to the first protrusion 123 than the first middle end 1143. The first sliding shaft 17 is able to slide between the first side end 1142 and the first middle end 1143.

In some implementations, the first connecting rod 16 includes a first upper plate 163 and a first lower plate 164 that are spaced apart, and a first receiving space 165 is defined between the first upper plate 163 and the first lower plate 164. When the card cover 12 is pulled away from or pushed toward the card tray 11, the connecting plate 114 extends out of or partially extends into the first receiving space 165.

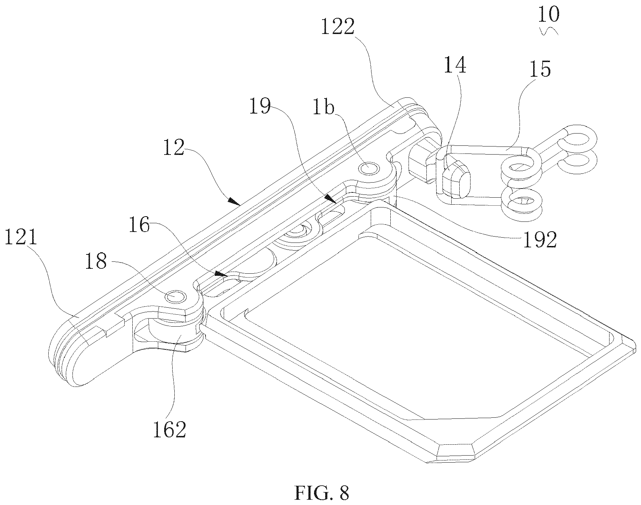

In this way, the connecting plate 114 can partially extend into the first receiving space 165, and the connecting plate 114 does not interfere with the first connecting rod 16, thereby further increasing the freedom of movement of the first connecting rod 16. Specifically, when the connecting plate 114 extends into the first receiving space 165, the first sliding shaft 17 is at the position of the first middle end 1143, and the first rotating end 162 is rotated to make the first connecting rod 16 be entirely in a position closer to the card cover 12. At this time, the card cover 12, the first connecting rod 16 and the card tray 11 are relatively compact (as illustrated in FIG 8).

Please continue to refer to FIGS. 7 to 9, in some implementations, the card cover 12 further includes a second projection 124 that extends toward the card tray 11. The card bracket 10 further includes a second connecting rod 19 that includes a second sliding end 191 and a second rotating end 192. The second sliding end 191 is slidably coupled to the connecting plate 114. The second rotating end 192 is rotatably coupled to the second protrusion 124. Pushing the card cover 12 toward or away from the card tray 11 can drive the second connecting rod 19 to slide relative to the connecting plate 114 and/or drive the second connecting rod 19 to rotate relative to the second protrusion 124.

Specifically, the second protrusion 124 is arranged near the second end 122, and the distance between the second protrusion 124 and the second end 122 may be equal to the distance between the first protrusion 123 and the first end 121. The protrusion height of the second protrusion 124 may be equal to the protrusion height of the first protrusion 123, and the shape of the second connecting rod 19 may be the same as the shape of the first connecting rod 16.

Thus, when the card cover 12 is pulled, the card cover 12 can simultaneously act on the card tray 11 through the first connecting rod 16 and the second connecting rod 19. Compared to the case in which only the first connecting rod 16 is provided, it is easier to control the direction in which the card tray 11 is pulled or pushed. It can be understood that, the motion state of the second connecting rod 19 includes a motion state in which the second sliding end 191 slides relative to the connecting plate 114 and the second rotating end 192 is stationary relative to the second protrusion 124; a motion state in which the second rotating end 192 rotates relative to the second protrusion 124 and the second sliding end 191 is stationary relative to the connecting plate 114; and a motion state in which the second rotating end 192 rotates relative to the second protrusion 124 and the second sliding end 191 slides relative to the connecting plate 114. Thus, the relative positional relationship between the card cover 12 and the card tray 11 is more diverse, so that the user can perform various operations on the card bracket 10.

Specifically, in some implementations, the connecting plate 114 is formed with a second sliding slot 1144, and the second projection 124 is formed with a second shaft hole 1242. The card bracket 10 further includes a second sliding shaft 1a and a second rotating shaft 1b. The second sliding shaft 1a passes through the second sliding slot 1144 and is fixedly connected to the second sliding end 191. The second sliding end 191 can drive the second sliding shaft 1a to slide in the second sliding slot 1144. The second sliding shaft 1a and the second sliding end 191 are integrally formed or separately formed. The second rotating shaft 1b passes through the second rotating end 192 and the second shaft hole 1242. The second rotating end 192 is rotatable about the second rotating shaft 1b.

Thus, the connection structures of the card tray 11, the card cover 12 and the second connecting rod 19 are simple and easy to disassemble and assemble. The extending direction of the second sliding slot 1144 may be perpendicular to the direction in which the card bracket 10 is inserted into the housing 20. The second sliding slot 1144 includes a second side end 1145 and a second middle end 1146. The second side end 1145 is closer to the second projection 124 than the second middle end 1146. The second sliding shaft 1a is able to slide between the second side end 1145 and the second middle end 1146. The extending direction of the second sliding slot 1144 is the same as the extending direction of the first sliding slot 1141.

In some implementations, the second connecting rod 19 includes a second upper plate 193 and a second lower plate 194 that are spaced apart, and a second receiving space 195 is defined between the second upper plate 193 and the second lower plate 194. When the card cover 12 is pulled away from or pushed toward the card tray 11, the connecting plate 114 extends out of or partially extends into the second receiving space 195.

In this way, the connecting plate 114 can partially extend into the second receiving space 195, and the connecting plate 114 does not interfere with the second connecting rod 19, thereby further increasing the freedom of movement of the second connecting rod 19. Specifically, when the connecting plate 114 partially extends into the first receiving space 165, the connecting plate 114 partially extends into the second receiving space 195 at the same time. At this time, the first sliding shaft 17 is at the position of the first middle end 1143, and the first rotating end 162 is rotated to make the first connecting rod 16 be entirely in a position closer to the card cover 12, the second sliding shaft 1a is at the position of the second middle end 1146, and the second rotating end 192 is rotated to make the second connecting rod 19 be entirely in a position closer to the card cover 12. At this time, the card cover 12, the first connecting rod 16, the second connecting rod 19, and the card tray 11 are relatively compact (as illustrated in Fig. 8).

In some implementations, the card cover 12 is provided with a receiving groove 125 on one side close to the card tray 11. When the card cover 12 is pushed toward the card tray 11, the first connecting rod 16 rotates relative to the first protrusion 123 and is finally received in the receiving groove 125, and the second connecting rod 19 rotates relative to the second protrusion 124 and is finally received in the receiving groove 125.

Thus, the first connecting rod 16 and the second connecting rod 19 can be received in the receiving groove 125, so that the structure of the card bracket 10 is compact. Further, when the first connecting rod 16 and the second connecting rod 19 are received in the receiving groove 125, the connecting plate 114 extends into the first receiving space 165 and the second receiving space 195, so that the card cover 12, the first connecting rod 16/the second connecting rod 19, and the connecting plate 114 are stacked to reduce the horizontal space occupied by the first connecting rod 16, the second connecting rod 19 and the connecting plate 114.

Specifically, the receiving groove 125 penetrates the first protrusion 123 and the second protrusion 124 to respectively divide the first protrusion 123 and the second protrusion 124 into upper and lower portions, where the first rotating end 162 is arranged between the upper and lower portions of the first protrusion 123, and the second rotating end 192 is arranged between the upper and lower portions of the second protrusion 124.

In the description of this specification, the description with reference to the terms "some implementation", "one implementations", "certain implementations", "example", "specific example", or "some examples", etc., mean that the specific features, structures, materials or characteristics described in the implementations or examples are included in at least one implementation or example of the present disclosure. In this specification, the illustrative expression of the above terms does not necessarily refer to the same implementation or example. Furthermore, the specific features, structures, materials, or characteristics described may be combined in a suitable manner in any one or more implementations or examples. In addition, without contradicting each other, those skilled in the art may combine various implementations or examples described in the specification, as well as features of the various implementations or examples.

Moreover, the terms "first" and "second" are used for descriptive purposes only and are not to be construed as indicating or implying a relative importance or implicitly indicating the number of technical features indicated. Thus, features defined as "first" or "second" may include at least one of the described features either explicitly or implicitly. In the description of the present disclosure, "a plurality of/multiple" means at least two, for example, two, three, unless otherwise specifically defined.

Although the implementations of the present disclosure have been illustrated and described, it is understood that, the above-described implementations are illustrative and are not to be construed as limiting the scope of the disclosure. Within the scope of the present disclosure, those skilled in the art may make changes, modifications, substitutions and alterations to the implementations, and the scope of the present disclosure is limited by the claims.

## Claims

1. A card bracket (10) applied to a terminal (100), the card bracket being capable of accommodating a data card (200) and being insertable into a housing (20) of the terminal, the card bracket comprising:
a card tray (11) configured to accommodate the data card; and
a card cover (12) coupled to the card tray and rotatable relative to the card tray, the card cover comprising a first end (121) and a second end (122) opposite to each other, the card cover further comprising a first protrusion (123) extending toward the card tray;
wherein when the card bracket is in a state of being inserted into the housing and a push force is applied to the first end, the card cover is rotatable about the first protrusion, to cause the first end to further extend into the housing while the second end to extend out of the housing;
**characterized in that**:
the card tray is provided with a connecting plate (114) at an end adjacent to the card cover, wherein the card bracket further comprises a first connecting rod (16), the first connecting rod comprising:
a first sliding end (161) slidably coupled to the connecting plate; and
a first rotating end (162) rotatably coupled to the first protrusion;
wherein the first connecting rod is driven to slide relative to the connecting plate, and/or the first connecting rod is driven to rotate relative to the first protrusion, by pushing the card cover toward or away from the card tray.

2. The card bracket of claim 1, wherein the connecting plate is provided with a first sliding slot (1141), and the first protrusion is formed with a first shaft hole (1232), wherein the card bracket further comprises:
a first sliding shaft (17) passing through the first sliding slot and fixedly connected to the first sliding end, wherein the first sliding end is able to drive the first sliding shaft to slide in the first sliding slot, wherein the first sliding shaft is integrally formed or separately formed with the first sliding end; and
a first rotating shaft (18) passing through the first rotating end and the first shaft hole, wherein the first rotating end is rotatable about the first rotating shaft.

3. The card bracket of claim 1, wherein the first connecting rod comprises a first upper plate (163) and a first lower plate (164) that are spaced apart, wherein the first upper plate and the first lower plate corporate to define a first receiving space (165) therebetween, wherein the connecting plate extends out of or partially extends into the first receiving space when the card cover is pulled away from or pushed toward the card tray.

4. The card bracket of claim 1, wherein the card cover further comprises a second protrusion (124) extending toward the card tray, the card bracket further comprising a second connecting rod (19), the second connecting rod comprising:
a second sliding end (191) slidably coupled to the connecting plate; and
a second rotating end (192) rotatably coupled to the second protrusion;
wherein the second connecting rod is driven to slide relative to the connecting plate, and/or the second connecting rod is driven to rotate relative to the second protrusion, by pushing the card cover toward or away from the card tray.

5. The card bracket of claim 4, wherein the connecting plate is provided with a second sliding slot (1144), and the second protrusion is formed with a second shaft hole (1242), wherein the card bracket further comprises:
a second sliding shaft (1a) passing through the second sliding slot and fixedly connected to the second sliding end, wherein the second sliding end is able to drive the second sliding shaft to slide in the second sliding slot, wherein the second sliding shaft is integrally formed or separately formed with the second sliding end; and
a second rotating shaft (1b) passing through the second rotating end and the second shaft hole, wherein the second rotating end is rotatable about the second rotating shaft.

6. The card bracket of claim 4, wherein the second connecting rod comprises a second upper plate (193) and a second lower plate (194) that are spaced apart, wherein the second upper plate and the second lower plate are corporate to define a second receiving space (195) therebetween, wherein the connecting plate extends out of or partially extends into the second receiving space when the card cover is pulled away from or pushed toward the card tray.

7. The card bracket of claim 4, wherein the card cover is provided with a receiving groove (125) on one side close to the card tray, wherein when the card cover is pushed toward the card tray, the first connecting rod rotates relative to the first protrusion and is finally received in the receiving groove, and the second connecting rod rotates relative to the second protrusion and is finally received in the receiving groove.

8. The card bracket of claim 1, wherein the card cover is provided with a first side surface (1212) at the first end and a second side surface (1222) at the second end wherein the first side surface gradually approaches a middle position of the card cover in a direction from the card tray to the card cover, and the second side surface is gradually away from the middle position of the card cover in the direction from the card tray to the card cover.

9. The card bracket of claim 1, wherein the card bracket further comprises a connecting element (14) extending from the second end toward the card tray, wherein when the card bracket is in a state of being inserted into the housing, the connecting element extends into the housing for connecting the card cover to the housing.

10. The card bracket of claim 9, wherein the card bracket further comprises a jointing element (15) arranged in the housing, wherein when the card bracket is in the state of being inserted into the housing, the connecting element is detachably connected to the jointing element, to connect the card cover with the housing.

11. The card bracket of claim 1, wherein the card bracket further comprises a sealing element (13) arranged on a sidewall of the card cover, wherein when the card cover extends into the housing, the sealing element is located between the card cover and the housing and seals a gap between the card cover and the housing.

12. A terminal (100) comprising:
a housing (20) provided with a card insertion groove (22); and
the card bracket of any one of claims 1 to 8 and 11, wherein the card bracket is insertable into the housing by extending into the card insertion groove.

13. The terminal of claim 12, wherein the card bracket further comprises a connecting element (14) extending from the second end toward the card tray and a jointing element (15) arranged in the housing; the housing further comprises a fixing element (24) on which the jointing element is fixedly arranged, wherein when the card bracket is in a state of being inserted into the housing, the jointing element is detachably connected to the connecting element, to connect the card cover with the housing.

14. The terminal of claim 12, wherein the terminal further comprises a card base (30) arranged in the housing, and the card base is provided with a guiding slot (32), wherein the card tray extends into the guiding slot when the card bracket is inserted into the housing.

## Patentansprüche

1. Kartenhalterung (10), die an einem Endgerät (100) angewendet wird, wobei die Kartenhalterung eine Datenkarte (200) aufnehmen kann und in ein Gehäuse (20) des Endgeräts einführbar ist, wobei die Kartenhalterung Folgendes umfasst:
ein Kartenfach (11), das zur Aufnahme der Datenkarte konfiguriert ist; und
eine Kartenabdeckung (12), die mit dem Kartenfach gekoppelt und bezüglich des Kartenfachs drehbar ist, wobei die Kartenabdeckung ein erstes Ende (121) und ein zweites Ende (122), die einander gegenüberliegen, umfasst, wobei die Kartenabdeckung ferner einen ersten Vorsprung (123), der sich zu dem Kartenfach hin erstreckt, umfasst,
wobei die Kartenabdeckung, wenn sich die Kartenhalterung in einem Zustand des Einführens in das Gehäuse befindet und eine Druckkraft an das erste Ende angelegt wird, dahingehend um den ersten Vorsprung herum drehbar ist, zu bewirken, dass sich das erste Ende weiter in das Gehäuse erstreckt, während sich das zweite Ende aus dem Gehäuse heraus erstreckt;
**dadurch gekennzeichnet, dass**:
das Kartenfach mit einer Verbindungsplatte (114) an einem Ende neben der Kartenabdeckung versehen ist, wobei die Kartenhalterung ferner eine erste Verbindungsstange (16) umfasst, wobei die erste Verbindungsstange Folgendes umfasst:
ein erstes verschiebbares Ende (161), das mit der Verbindungsplatte verschiebbar gekoppelt ist; und
ein erstes drehbares Ende (162), das mit dem ersten Vorsprung drehbar gekoppelt ist;
wobei die erste Verbindungsstange dahingehend angetrieben wird, sich bezüglich der Verbindungsplatte zu verschieben, und/oder die erste Verbindungsstange dahingehend angetrieben wird, sich bezüglich des ersten Vorsprungs zu drehen, indem die Kartenabdeckung zum Kartenfach hin oder von diesem weg gedrückt wird.

2. Kartenhalterung nach Anspruch 1, wobei die Verbindungsplatte mit einem ersten Gleitschlitz (1141) versehen ist und der erste Vorsprung mit einer ersten Wellenöffnung (1232) ausgebildet ist, wobei die Kartenhalterung ferner Folgendes umfasst:
eine erste verschiebbare Welle (17), die durch den ersten Gleitschlitz hindurchgeht und mit dem ersten verschiebbaren Ende fest verbunden ist, wobei das erste verschiebbare Ende die erste verschiebbare Welle dahingehend antreiben kann, sich in dem ersten Gleitschlitz zu verschieben, wobei die erste verschiebbare Welle mit dem ersten verschiebbaren Ende integral ausgebildet oder davon separat ausgebildet ist; und
eine erste drehbare Welle (18), die durch das erste drehbare Ende und die erste Wellenöffnung hindurchgeht, wobei das erste drehbare Ende um die erste drehbare Welle herum drehbar ist.

3. Kartenhalterung nach Anspruch 1, wobei die erste Verbindungsstange eine erste obere Platte (163) und eine erste untere Platte (164), die voneinander beabstandet sind, umfasst, wobei die erste obere Platte und die erste untere Platte dahingehend zusammenwirken, einen ersten Aufnahmeraum (165) dazwischen zu definieren, wobei sich die Verbindungsplatte aus dem ersten Aufnahmeraum heraus erstreckt oder sich zum Teil in diesen hinein erstreckt, wenn die Kartenabdeckung von dem Kartenfach weggezogen oder zu diesem gedrückt wird.

4. Kartenhalterung nach Anspruch 1, wobei die Kartenabdeckung ferner einen zweiten Vorsprung (124) umfasst, der sich zu dem Kartenfach hin erstreckt, wobei die Kartenhalterung ferner eine zweite Verbindungsstange (19) umfasst, wobei die zweite Verbindungsstange Folgendes umfasst:
ein zweites verschiebbares Ende (191), das mit der Verbindungsplatte verschiebbar gekoppelt ist; und ein zweites drehbares Ende (192), das mit dem zweiten Vorsprung drehbar gekoppelt ist;
wobei die zweite Verbindungsstange dahingehend angetrieben wird, sich bezüglich der Verbindungsplatte zu verschieben, und/oder die zweite Verbindungsstange dahingehend angetrieben wird, sich bezüglich des zweiten Vorsprungs zu drehen, indem die Kartenabdeckung zum Kartenfach hin oder von diesem weg gedrückt wird.

5. Kartenhalterung nach Anspruch 4, wobei die Verbindungsplatte mit einem zweiten Gleitschlitz (1144) versehen ist und der zweite Vorsprung mit einer zweiten Wellenöffnung (1242) ausgebildet ist, wobei die Kartenhalterung ferner Folgendes umfasst:
eine zweite verschiebbare Welle (la), die durch den zweiten Gleitschlitz hindurchgeht und mit dem zweiten verschiebbaren Ende fest verbunden ist, wobei das zweite verschiebbare Ende die zweite verschiebbare Welle dahingehend antreiben kann, sich in dem zweiten Gleitschlitz zu verschieben, wobei die zweite verschiebbare Welle mit dem zweiten verschiebbaren Ende integral ausgebildet oder davon separat ausgebildet ist; und
eine zweite drehbare Welle (1b), die durch das zweite drehbare Ende und die zweite Wellenöffnung hindurchgeht, wobei das zweite drehbare Ende um die zweite drehbare Welle herum drehbar ist.

6. Kartenhalterung nach Anspruch 4, wobei die zweite Verbindungsstange eine zweite obere Platte (193) und eine zweite untere Platte (194), die voneinander beabstandet sind, umfasst, wobei die zweite obere Platte und die zweite untere Platte dahingehend zusammenwirken, einen zweiten Aufnahmeraum (195) dazwischen zu definieren, wobei sich die Verbindungsplatte aus dem zweiten Aufnahmeraum heraus erstreckt oder sich zum Teil in diesen hinein erstreckt, wenn die Kartenabdeckung von dem Kartenfach weggezogen oder zu diesem gedrückt wird.

7. Kartenhalterung nach Anspruch 4, wobei die Kartenabdeckung mit einer Aufnahmenut (125) auf einer Seite in der Nähe des Kartenfachs versehen ist, wobei, wenn die Kartenabdeckung zu dem Kartenfach hin gedrückt wird, sich die erste Verbindungsstange bezüglich des ersten Vorsprungs dreht und letztlich in der Aufnahmenut aufgenommen wird, und sich die zweite Verbindungsstange bezüglich des zweiten Vorsprungs dreht und letztlich in der Aufnahmenut aufgenommen wird.

8. Kartenhalterung nach Anspruch 1, wobei die Kartenabdeckung mit einer ersten Seitenfläche (1212) an dem ersten Ende und einer zweiten Seitenfläche (1222) an dem zweiten Ende versehen ist, wobei sich die erste Seitenfläche nach und nach in einer von dem Kartenfach zu der Kartenabdeckung verlaufenden Richtung einer mittigen Position der Kartenabdeckung nähert und sich die zweite Seitenfläche nach und nach in der von dem Kartenfach zu der Kartenabdeckung laufenden Richtung von der mittigen Position der Kartenabdeckung entfernt.

9. Kartenhalterung nach Anspruch 1, wobei die Kartenhalterung ferner ein Verbindungselement (14) umfasst, das sich von dem zweiten Ende zu dem Kartenfach hin erstreckt, wobei, wenn sich die Kartenhalterung in einem Zustand des Einführens in das Gehäuse befindet, sich das Verbindungselement zur Verbindung der Kartenabdeckung mit dem Gehäuse in das Gehäuse erstreckt.

10. Kartenhalterung nach Anspruch 9, wobei die Kartenhalterung ferner ein Kopplungselement (15) umfasst, das in dem Gehäuse angeordnet ist, wobei, wenn sich die Kartenhalterung in dem Zustand des Einführens in das Gehäuse befindet, das Verbindungselement zur Verbindung der Kartenabdeckung mit dem Gehäuse lösbar mit dem Kopplungselement verbunden ist.

11. Kartenhalterung nach Anspruch 1, wobei die Kartenhalterung ferner ein Dichtungselement (13) umfasst, das an einer Seitenwand der Kartenabdeckung angeordnet ist, wobei, wenn sich die Kartenabdeckung in das Gehäuse erstreckt, das Dichtungselement zwischen der Kartenabdeckung und dem Gehäuse positioniert ist und einen Spalt zwischen der Kartenabdeckung und dem Gehäuse abdichtet.

12. Endgerät (100), das Folgendes umfasst:
ein Gehäuse (20), das mit einer Karteneinführungsnut (22) versehen ist; und
die Kartenhalterung nach einem der Ansprüche 1-8 und 11,
wobei die Kartenhalterung durch Erstreckung in die Karteneinführungsnut in das Gehäuse einführbar ist.

13. Endgerät nach Anspruch 12, wobei die Kartenhalterung ferner ein Verbindungselement (14), das sich von dem zweiten Ende zu dem Kartenfach hin erstreckt, und ein Kopplungselement (15), das in dem Gehäuse angeordnet ist, umfasst; wobei das Gehäuse ferner ein Fixierungselement (24) umfasst, an dem das Kopplungselement fest angeordnet ist, wobei wenn sich die Kartenhalterung in einem Zustand des Einführens in das Gehäuse befindet, das Kopplungselement zur Verbindung der Kartenabdeckung mit dem Gehäuse lösbar mit dem Verbindungselement verbunden ist.

14. Endgerät nach Anspruch 12, wobei das Endgerät ferner eine Kartenbasis (30) umfasst, die in dem Gehäuse angeordnet ist, und die Kartenbasis mit einem Führungsschlitz (32) versehen ist, wobei sich das Kartenfach in den Führungsschlitz erstreckt, wenn die Kartenhalterung in das Gehäuse eingeführt ist.

## Revendications

1. Support de carte (10) appliqué à un terminal (100), le support de carte étant susceptible de loger une carte de données (200) et étant insérable dans un boîtier (20) du terminal, le support de carte comprenant :
un tiroir de carte (11) configuré pour loger la carte de données ; et
un cache de carte (12) accouplé au tiroir de carte et pouvant tourner par rapport au tiroir de carte, le cache de carte comprenant une première extrémité (121) et une deuxième extrémité (122) opposées l'une à l'autre, le cache de carte comprenant en outre une première saillie (123) s'étendant vers le tiroir de carte ;
dans lequel, lorsque le support de carte est dans un état dans lequel il est inséré dans le boîtier et une force de poussée est appliquée à la première extrémité, le cache de carte peut tourner autour de la première saillie, pour amener la première extrémité à s'étendre davantage dans le boîtier tandis que la deuxième extrémité s'étend hors du boîtier ;
**caractérisé en ce que** :
le tiroir de carte est doté d'une plaque de connexion (114) à une extrémité adjacente au cache de carte, le support de carte comprenant en outre une première tige de connexion (16), la première tige de connexion comprenant :
une première extrémité coulissante (161) accouplée de manière coulissante à la plaque de connexion ; et
une première extrémité rotative (162) accouplée en rotation à la première saillie ;
la première tige de connexion étant entraînée de manière à coulisser par rapport à la plaque de connexion, et/ou la première tige de connexion étant entraînée pour tourner par rapport à la première saillie, en poussant le cache de carte vers le tiroir de carte ou à l'écart de celui-ci.

2. Support de carte de la revendication 1, dans lequel la plaque de connexion est dotée d'une première fente de coulissement (1141), et la première saillie est pourvue d'un premier trou pour arbre (1232), dans lequel le support de carte comprend en outre :
un premier arbre coulissant (17) traversant la première fente de coulissement et connecté fixement à la première extrémité coulissante, dans lequel la première extrémité coulissante est apte à entraîner le premier arbre coulissant pour coulisser dans la première fente de coulissement, dans lequel le premier arbre coulissant est formé d'un seul tenant avec la première extrémité coulissante ou formé séparément de celle-ci ; et
un premier arbre rotatif (18) traversant la première extrémité rotative et le premier trou pour arbre, dans lequel la première extrémité rotative peut tourner autour du premier arbre rotatif.

3. Support de carte de la revendication 1, dans lequel la première tige de connexion comprend une première plaque supérieure (163) et une première plaque inférieure (164) qui sont espacées l'une de l'autre, dans lequel la première plaque supérieure et la première plaque inférieure coopèrent pour définir un premier espace de réception (165) entre elles, dans lequel la plaque de connexion s'étend hors du premier espace de réception ou s'étend partiellement dans celui-ci lorsque le cache de carte est tiré à l'écart du tiroir de carte ou poussé vers celui-ci.

4. Support de carte de la revendication 1, dans lequel le cache de carte comprend en outre une deuxième saillie (124) s'étendant vers le tiroir de carte, le support de carte comprenant en outre une deuxième tige de connexion (19), la deuxième tige de connexion comprenant :
une deuxième extrémité coulissante (191) accouplée de manière coulissante à la plaque de connexion ; et
une deuxième extrémité rotative (192) accouplée en rotation à la deuxième saillie ;
dans lequel la deuxième tige de connexion est entraînée de manière à coulisser par rapport à la plaque de connexion, et/ou la deuxième tige de connexion est entraînée pour tourner par rapport à la deuxième saillie, en poussant le cache de carte vers le tiroir de carte ou à l'écart de celui-ci.

5. Support de carte de la revendication 4, dans lequel la plaque de connexion est dotée d'une deuxième fente de coulissement (1144), et la deuxième saillie est pourvue d'un deuxième trou pour arbre (1242), dans lequel le support de carte comprend en outre :
un deuxième arbre coulissant (la) traversant la deuxième fente de coulissement et connecté fixement à la deuxième extrémité coulissante, dans lequel la deuxième extrémité coulissante est apte à entraîner le deuxième arbre coulissant pour coulisser dans la deuxième fente de coulissement, dans lequel le deuxième arbre coulissant est formé d'un seul tenant avec la deuxième extrémité coulissante ou formé séparément de celle-ci ; et
un deuxième arbre rotatif (1b) traversant la deuxième extrémité rotative et le deuxième trou pour arbre, dans lequel la deuxième extrémité rotative peut tourner autour du deuxième arbre rotatif.

6. Support de carte de la revendication 4, dans lequel la deuxième tige de connexion comprend une deuxième plaque supérieure (193) et une deuxième plaque inférieure (194) qui sont espacées l'une de l'autre, dans lequel la deuxième plaque supérieure et la deuxième plaque inférieure coopèrent pour définir un deuxième espace de réception (195) entre elles, dans lequel la plaque de connexion s'étend hors du deuxième espace de réception ou s'étend partiellement dans celui-ci lorsque le cache de carte est tiré à l'écart du tiroir de carte ou poussé vers celui-ci.

7. Support de carte de la revendication 4, dans lequel le cache de carte est doté d'une rainure de réception (125) sur un côté proche du tiroir de carte, dans lequel, lorsque le cache de carte est poussé vers le tiroir de carte, la première tige de connexion tourne par rapport à la première saillie et est finalement reçue dans la rainure de réception, et la deuxième tige de connexion tourne par rapport à la deuxième saillie et est finalement reçue dans la rainure de réception.

8. Support de carte de la revendication 1, dans lequel le cache de carte est doté d'une première surface latérale (1212) à la première extrémité et d'une deuxième surface latérale (1222) à la deuxième extrémité, dans lequel la première surface latérale se rapproche graduellement d'une position centrale du cache de carte dans une direction allant du tiroir de carte vers le cache de carte, et la deuxième surface latérale s'éloigne graduellement de la position centrale du cache de carte dans la direction allant du tiroir de carte vers le cache de carte.

9. Support de carte de la revendication 1, le support de carte comprenant en outre un élément de connexion (14) s'étendant à partir de la deuxième extrémité vers le tiroir de carte, et lorsque le support de carte est dans un état dans lequel il est inséré dans le boîtier, l'élément de connexion s'étendant dans le boîtier pour connecter le cache de carte au boîtier.

10. Support de carte de la revendication 9, le support de carte comprenant en outre un élément de raccordement (15) agencé dans le boîtier, et lorsque le support de carte est dans l'état dans lequel il est inséré dans le boîtier, l'élément de connexion étant connecté de manière détachable à l'élément de raccordement, pour connecter le cache de carte au boîtier.

11. Support de carte de la revendication 1, le support de carte comprenant en outre un élément d'étanchéité (13) agencé sur une paroi latérale du cache de carte, et lorsque le cache de carte s'étend dans le boîtier, l'élément d'étanchéité étant situé entre le cache de carte et le boîtier et fermant hermétiquement un interstice entre le cache de carte et le boîtier.

12. Terminal (100) comprenant :
un boîtier (20) doté d'une rainure d'insertion de carte (22) ; et
le support de carte de l'une quelconque des revendications 1 à 8 et 11,
dans lequel le support de carte est insérable dans le boîtier par extension dans la rainure d'insertion de carte.

13. Terminal de la revendication 12, dans lequel le support de carte comprend en outre un élément de connexion (14) s'étendant à partir de la deuxième extrémité vers le tiroir de carte et un élément de raccordement (15) agencé dans le boîtier ; le boîtier comprenant en outre un élément de fixation (24) sur lequel l'élément de raccordement est agencé fixement, dans lequel, lorsque le support de carte est dans un état dans lequel il est inséré dans le boîtier, l'élément de raccordement est connecté de manière détachable à l'élément de connexion, pour connecter le cache de carte au boîtier.

14. Terminal de la revendication 12, le terminal comprenant en outre une base de carte (30) agencée dans le boîtier, et la base de carte étant dotée d'une fente de guidage (32), le tiroir de carte s'étendant dans la fente de guidage lorsque le support de carte est inséré dans le boîtier.
